# EUROPEAN PATENT SPECIFICATION

(11) **EP 0 512 631 B1**
(45) Date of publication and mention of the grant of the patent: **13.08.1997**
(21) Application number: 92201230.7
(22) Date of filing: 02.05.1992
(51) Int. Cl.: H02H 7/20, H02H 1/04, H01L 27/02

(54) **Circuit for protection against the increase of the output current for an integrated circuit comprising a power device driving a resonant load connected to a power supply**
Schaltkreis zum Schutz gegen einen Anstieg des Ausgangsstroms einer integrierten Schaltung, die ein Leistungselement beinhaltet, das eine an eine Leistungsversorgung geschaltete resonante Last steuert
Circuit pour la protection contre un accroissement du courant de sortie d'un circuit intégré comprenant un élément de puissance pilotant une charge résonante reliée à une source de puissance

(30) Priority: 09.05.1991 IT MI911266
(43) Date of publication of application: 11.11.1992
(73) Proprietor: CONSORZIO PER LA RICERCA SULLA MICROELETTRONICA NEL MEZZOGIORNO, 95121 Catania (IT)
(72) Inventor: Palara, Sergio, I-95021 Acicastello (Catania) (IT); Sueri, Stefano, I-95129 Catania (IT)
(74) Representative: Mittler, Enrico

(56) References cited:
- EP-A- 0 260 120
- EP-A- 0 343 536
- EP-A- 0 396 167
- PATENT ABSTRACTS OF JAPAN vol. 13, no. 196 (E-755) 10 May 1989 & JP-A-10 18 238
- PATENT ABSTRACTS OF JAPAN vol. 10, no. 329 (E-452) 8 November 1986 & JP-A-61 135 159
- SIEMENS FORSCHUNGS- UND ENTWICKLUNGSBERICHTE, vol. 17, no. 1, 1988, Berlin DE, pp. 27-34; G. MILLER et al.: 'SIRET, a 1000 V Bipolar Transistor with no Two-Dimensional Parasitic Effects'

## Description

The present invention relates to a circuit for protection against the increase of the output current for an integrated circuit comprising a power device driving a resonant load connected to a power supply.

In an electronic ignition system for an internal combustion engine there is a resonant load constituted by an ignition coil driven by a semi-conductor power switching device, normally constituted by a transistor, which is operated by input voltage pulses of duration such as to allow the current passing through the coil to reach a predetermined value.

The switch's input voltage can vary between a low value at which the switch is open and a high value at which the switch is closed thus allowing the passage of current in the coil. More accurately, if the switch is constituted by a transistor, so long as the input voltage is low the transistor's collector current is nil and thus the transistor is off and behaves like an open switch; when the input voltage goes high, the transistor is on and behaves like a closed switch and the transistor's collector current, constituting the power device's output current, starts to rise in a linear manner.

If for accidental reasons the input voltage continues to remain high beyond the due time, the transistor continues to remain on and thus the semi-conductor switch continues to remain closed. As a consequence the collector current continues to rise; the latter shall be limited only by the series resistance of the coil's primary and of the switch.

Such enormous increase in the collector current causes an unacceptable power dissipation in the transistor causing its destruction.

The transistor is also destroyed when making use of the traditional method used in electronic ignition systems, which provides for limiting the collector current to a maximum preset value.

In fact, in this case the transistor desaturates and as a consequence almost all the coil's supply voltage falls across the transistor itself, causing a power dissipation that destroys it in a few seconds.

A known method for protecting the power transistor is that of quenching it when the collector current reaches a preset value, independently of the fact that the input control voltage continues to remain high for an indefinite time.

In such case the protection circuit provides for the presence of a clamping or latch circuit which at input, through a comparator, senses that the power transistor's collector current has reached a maximum value and then arranges itself in a state wherein it operates a control circuit of the power transistor causing the transistor itself to be switched off.

The clamping circuit remains in such a state, ignoring other inputs that might reach it from the comparator, until it is reset in its primary condition by a signal obtained from the input voltage when this goes low.

The provision of this protection circuit in the form of an integrated circuit with a technology which allows to have on the same silicon chip the power transistor and the protection circuit (for example, a vertical-flow structure known as VIPower) exhibits considerable operating problems.

During the ignition or quenching step of the power transistor (or darlington) the collector of the transistor itself, which is also the substrate of the chip on which the integrated circuit is formed, exhibits some voltage transients which take its potential to a few volts below that of ground. This leads as a consequence to the ignition of the vertical parasite transistors inherent in the technological structure of the integrated protection circuit.

Obviously the ignition of the parasite transistors jeopardizes the correct operation of the protection circuit, were it indeed to be provided in integrated technology since there is a clamping circuit inside it. The abovementioned ignition in fact causes the erasure of the information stored in the clamping circuit itself.

As a consequence, the protection circuit described above does not solve the problem of the destruction of the power transistor when the circuit itself is provided in the integrated form with a technological structure that also includes the power transistor.

To understand this concept better let us consider that in an initial condition with a low-level input voltage the power transistor is off. The voltage across the power transistor's collector is equal to the supply voltage applied across the ignition coil, which is thus subjected to a voltage difference that is nil. The current flowing through the coil primary is consequently nil.

When the input goes high, the power transistor is switched on and the voltage across its collector is equal to the saturation voltage.

After a first interval of some 50 microseconds, due to the particular features of the ignition coil, there is a first underground, i.e. a lowering of the power transistor's collector voltage below the ground voltage of the integrated circuit, that lasts some 10 microseconds; then the power transistor's collector voltage goes back to being positive and equal to the saturation voltage.

When the collector current reaches a maximum preset value, the clamping circuit intervenes and switches off the power transistor's control circuit; the collector current is cut off and an overvoltage is created across the power transistor's collector that causes a spark on the coil's secondary.

During the discharge of the secondary the collector voltage maintains a value that is intermediate between the supply voltage and ground. When the discharge is over, and thus after a second interval of some 2 milliseconds from the time when the collector current is switched off, there is a second underground of the collector voltage, that lasts 10 microseconds.

During the operation of the protection circuit, if this is accomplished in a single circuit integrated with the power transistor, there are the following problems.

After said first time interval the clamping circuit must be inactive, while, on the other hand, the first underground of the power transistor's collector voltage can activate it and undesirably switch off the power transistor's control circuit.

After said second time interval the clamping circuit must be active even if the input voltage continues to remain high. Since an underground takes place, the clamping circuit can lose the information that it had stored and could reset itself giving rise to a new ignition of the control circuit.

The object of the present invention is to provide a protection circuit that can be obtained in a form integrated with the power device, at the same time avoiding the drawbacks mentioned above.

According to the invention such object is attained through an integrated circuit as defined in claim 1.

In such a way the circuit is not affected by the disturbances due to undergrounds of the power device's supply voltage and operates correctly.

The features of the present invention shall be made more evident by an embodiment illustrated as a non-limiting example in the enclosed drawings, wherein:
Fig. 1 illustrates a circuit diagramme according to the present invention;
Fig. 2 illustrates a circuit embodiment of the clamping circuit included in the protection circuit illustrated in Fig. 1;
Fig. 3 illustrates an integrated circuit embodiment of the protection circuit according to the present invention;
Fig.s 4-7 illustrate the curves of some waveforms present in the circuit of Fig. 1.

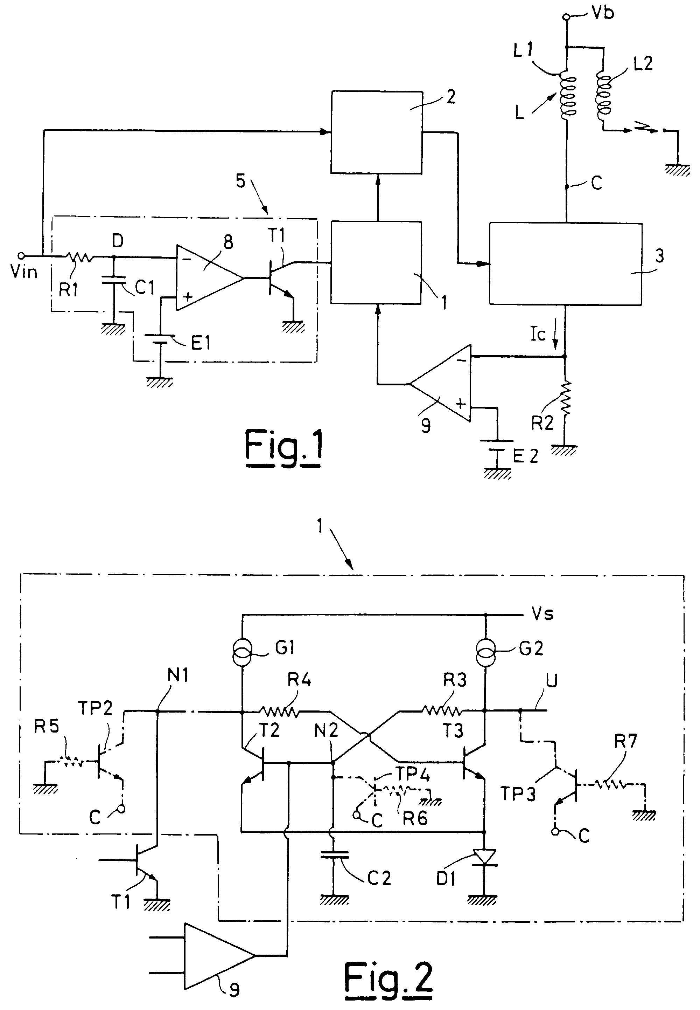

With reference to Fig. 1, a clamping circuit 1 is associated with a control circuit 2 that switches on and off the power device 3, for example a transistor of the type NPN, in turn suitable for driving a resonant load L connected to a battery power supply Vb. Said resonant load is, for example, constituted by an ignition coil for an internal combustion engine with a primary winding L1 and a secondary winding L2.

The control circuit 2 is supplied with an input pulse voltage signal Vin, that can be made to vary between a low value and a high value, for the disactivation and activation, respectively, of the control circuit 2.

Between the input Vin and the clamping circuit 1 there are interposed first circuit means 5 suitable for inhibiting the operation of the clamping circuit 1 for a preset time interval after reaching a state of high voltage at the input Vin. Said first means 5 comprise a network RC consisting of a resistance R1 and a capacitor C1, a comparator 8 having an input connected to a node D that is intermediate between the resistance R1 and the capacitor C1 and another input connected to a threshold voltage generator E1, and a transistor T1 of the type NPN having the base connected to the output of the comparator 8, the emitter connected to ground and the collector connected to an input of the clamping circuit 1.

Between the power device 3 and the clamping circuit 1 there is interposed a comparator 9 suitable for activating said clamping circuit 1 when the current flowing through the power device reaches a maximum value Icmax. An input of the comparator 9 is connected to a reference voltage generator E2, while the other input is connected to a node that is intermediate between the power device 3 and a detection resistance R2 whose other end is grounded.

With reference to Fig. 2, the clamping circuit 1 comprises an input transistor T2 and an output transistor T3 with the emitters connected together and to ground through a diode D1. The collectors of the transistors T2, T3 of the type NPN are connected through current generators G1, G2 to a supply voltage Vs. The base of the input transistor T2 is connected to the output of the comparator 9, as well as through a resistance R3 to the collector of the transistor T3 and thus to the output U of the clamping circuit 1, while the base of the output transistor T3 is connected through a resistance R4 to the collector of the transistor T2 and to a circuit node N1, which represents an input of the clamping circuit 1 and is connected to the collector of the transistor T1. To a node that is intermediate between the resistance R3 and the base of the input transistor T2 there is connected an armature of a second capacitor C2, whose other armature is grounded.

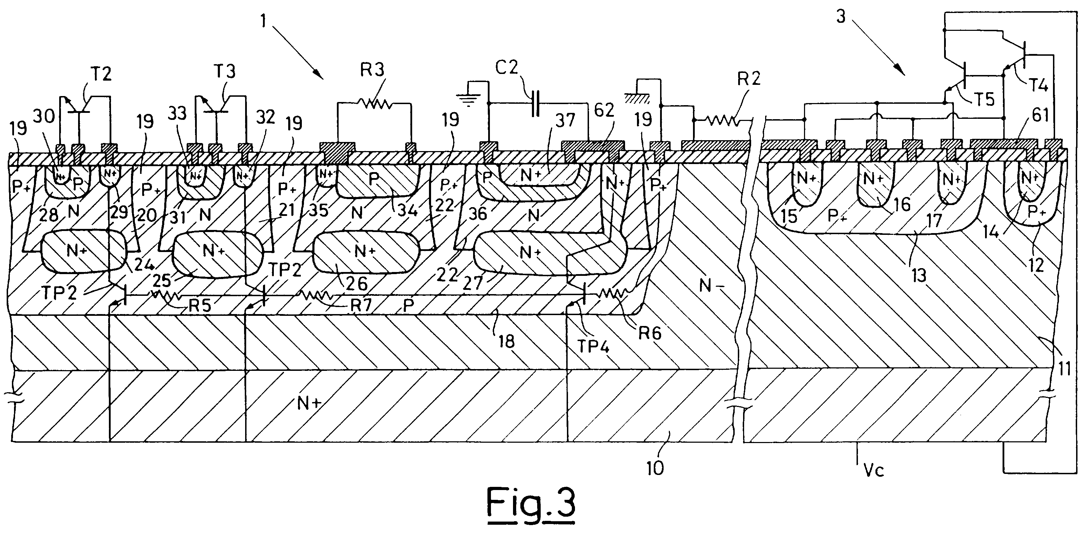

If the clamping circuit 1 and the power device 3 are provided in the form of an integrated circuit, which shall be described later with reference to Fig. 3, parasite transistors TP2, TP3, TP4 are formed, that are indicated in Fig. 2 with a dotted line. The emitters of the parasite transistors are connected to the terminal C of the power device 3 (essentially the collector of the NPN transistor) and the bases are connected to ground through resistances R5, R6, R7. The collector of the transistor TP2 is connected to the collector of the input transistor T2. The collector of the transistor TP3 is connected to the collector of the output transistor T3, the collector of the transistor TP4 is connected at the circuit node N2 to the base of the input transistor T2.

To better to explain the existence of said parasite transistors, there is shown in Fig. 3 a part of an integrated circuit which includes the clamping circuit 1 and the power device 3. On a substrate 10, of the type N+, which constitutes the collector at voltage Vc of the power device, there is an epitaxial layer 11 of the type N-, inside which there is a region 12 of the type P+ which constitutes the base of one (T4) of two transistors T4, T5 connected in a darlington configuration which together form the power device 3. Inside the region 12 there is a region 14 of the type N+ which constitutes the emitter of the transistor T4 and is connected through a surface metallization 61 to a region 13 of the type P+, which constitutes the base of the transistor T5 and in turn contains regions 15, 16, 17 of the type N+ suitable for constituting the emitter of the transistor T5. The collectors of the transistors T4, T5, connected together, are constituted by the substrate 10 of the type N+. Between the emitters of the transistors T4, T5 and ground there is the metallization resistance R2.

Inside the epitaxial layer 11 there is also an insulation well 18 of the type P which extends to the surface in vertical regions 19 of the type P+. Between the vertical regions 19 there are epitaxial regions 20, 21, 22, 23 of the type N. Between the deep region 18 of the type P and said regions 20, 21, 22, 23 there are enriched regions 24, 25, 26, 27 of the type N+. The region 27 of the type N+ extends to the surface of the semi-conductor.

Inside region 20 there are regions 28, 29 of the type P and of the type N+, respectively. In the region 28 there is a region 30 of the type N+. The regions 28, 29 and 30 constitute the base, the collector and the emitter of the input transistor T2. The region 29, the substrate 10 and the region 18 represent the collector, the emitter and the base of the parasite transistor TP2, which is formed in association with the transistor T2.

Inside the region 21 there are regions 31, 32 of the type P and of the type N+, respectively. In the region 31 there is an under-region 33 of the type N+. The regions 31, 32 and 33 constitute the base, the collector and the emitter of the output transistor T3. The region 32, the substrate 10 and the region 18 represent the collector, the emitter and the base of the parasite transistor TP3 associated with the transistor T3.

Inside the region 22 there are regions 34 of the type P and 35 of the type N+, suitable, together, for constituting the diffuse resistance R3. Similar regions not represented are suitable for constituting the diffuse resistance R4.

Inside the region 23 there are regions 36 of the type P and 37 of the type N+. The region 36 and the region 37 represent together the capacity C2. A surface metallization 62 connects the region 37 to the adjacent region 27.

The region 27 of the type N+ represents the collector of the parasite transistor TP4, associated with the capacitor C2. The emitter of the parasite transistor TP4 is constituted by the substrate 10, while the base is constituted by the region 18 of the type P. Said parasite transistor TP4 is such as to constitute a high-voltage transistor having a breakdown voltage that is higher than that which appears across the primary of the coil L.

In the regions 18 there are also defined the base resistances R5, R7 and R6 of the parasite transistors TP2, TP3 and TP4.

Between the emitter of the output transistor T3, constituted by the region 33, and ground there is accomplished in a manner known in itself, but not shown, the diode D1.

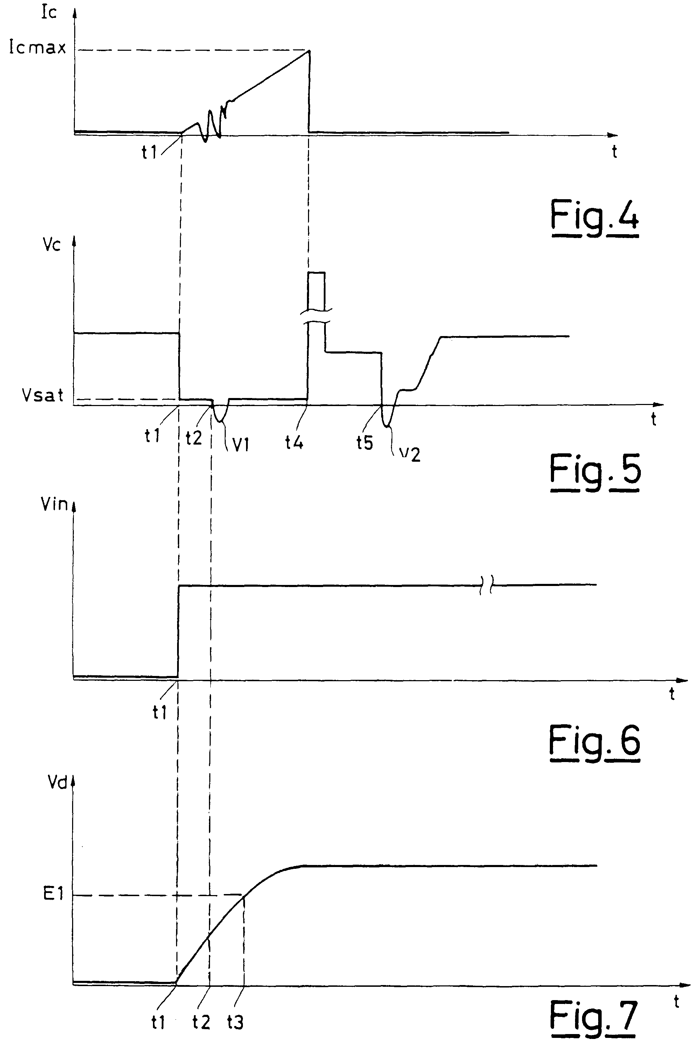

With reference to Fig.s 1 and 2 and keeping in mind the parasite transistors inherent in the integrated structure of Fig. 3, the circuit according to the invention operates in the following manner, illustrated by the waveforms of the current Ic, Fig. 4, and of the voltage Vc, Fig. 5, on the collector of the power device T4, T5, of the input voltage Vin, Fig. 6, and of the voltage Vd, Fig. 7, across the circuit node D at input to the comparator 8.

Initially Vin is low, the clamping circuit 1 with output U high is off, the control circuit 2 is inactive, the power device 3 is off.

The voltage Vc across the collector of the power device 3 is equal to the voltage Vb of the supply battery, the current Ic on the collector of the power device 3 is nil.

When the input Vin goes high, instant t1, the control circuit 2 is activated and switches the power device 2 on. The voltage Vc across the collector of the power device 3 moves to the saturation voltage Vsat. The current Ic on the collector of the power device 3 starts to rise.

In the meantime the voltage Vin starts charging the first capacitor C1.

Since the voltage across the capacitor C1 is less than E1, the comparator 8 continues to keep the transistor T1 switched on which with its low output keeps the clamping circuit 1 inhibited.

At a time instant t2, on the collector of the power device 3 there is a first underground (i.e. a collector voltage lower than the ground voltage of the integrated circuit) with peak voltage V1 and duration equal to some 10 microseconds.

This causes the parasite transistors TP2, TP3, TP4 to be switched on, with the consequent drop to the low level of the output voltage of the clamping circuit 1, which should be on.

But the time t2 added to the duration of the first underground is less than that, indicated with t3 which the capacitor C1 takes to charge itself at the voltage E1. Thus the comparator 8 continues to keep the transistor T1 switched on and through it to keep the clamping circuit 1 inhibited.

Some 10 microseconds after t2, the voltage Vc rises again above ground. The output voltage U of the clamping circuit 1 is high, so that the latter is off and as a consequence does not cause the control circuit 2 to cut off the power device 3.

This in particular occurs since TP2, TP3, TP4 are switched off, while T1 is switched on up to the instant t3 and keeps T3 switched off, so that the voltage U is high and the clamping circuit 1 is off. The high voltage U causes as a consequence the conduction of T2, whose low collector voltage continues to keep T3 switched off and thus U high.

At the instant t3, greater than the sum of the time t2 and of the time interval of the first underground of the collector voltage of the power device 3, the voltage across the capacitor C1 reaches the value E1. The comparator 8 is triggered and cuts the transistor T1 off and the state of the clamping circuit 1 remains unchanged.

From this instant the clamping circuit 1 is no longer inhibited and can switch itself on as a result of a switch-on command from the comparator 9.

When the current value Icmax is reached, instant 4, the comparator 9 is triggered and commands the ignition of the clamping circuit 1.

In such a situation the output of the comparator 9 sends the base of the input transistor T2 low and thus switches it off; as a consequence the output transistor T3 is activated and the output U of the clamping circuit 1 goes low.

The output U acts on the control circuit 2, which switches the power device 3 off.

At this point the clamping circuit 1 has reached the active state and continues to remain in such a state for the whole time in which the input voltage Vin remains high independently of the disturbances on the power supply and thus on the collector of the power device 3.

Such disturbance, as can be seen from the curve Vc in Fig. 5, occurs at a time instant t5.

At that moment the occurrence of a second underground at a voltage V2 in fact causes the conduction of the parasite transistors TP2, TP3. These force the voltage across the output U to remain low. TP4 is also activated, which is the parasite transistor of the capacitor C2. During this second underground the capacitor C2 discharges through the parasite transistor TP4.

After about 10 microseconds the second underground is exhausted, but the clamping circuit 1 continues to maintain the state of U low; a contribution to this is made by the capacitor C1. In fact the clamping circuit 1 has a preferential state of low U until the capacitor C2 coincident with the base of the input transistor T2 has not been charged at a voltage equal to 2Vbe=(Vbe(T2)+Vbe(D1)) .

During this step the diode D1 is used to increase the ignition threshold of the transistor T2 from 1Vbe to 2Vbe. This increases the safeness that T2 shall remain off even taking into account the fact that C2 takes longer to charge itself at 2Vbe than at 1Vbe.

Before the capacitor C2 charges itself through the voltage U and R3 at a voltage value equal to 2Vbe, the input transistor T2 is obviously switched off, with the result that T3 must be switched on, keeping U low. The capacitor C2 and its charging resistance R3 are of such a size that the charging of C2 takes place in a time greater than the duration of the second underground.

Once the capacitor C2 has charged itself at a voltage equal to(Vbe(D1)+Vsat(T3) , after the second underground is over, this does not disturb the clamping circuit 1, which remains with T3 switched on and U low, since this voltage across C2 is less than the minimum voltage necessary to trigger T2, that is (Vbe(T2)+Vbe(D1)).

In this manner the circuit according to the invention is not affected by the disturbances due to the undergrounds and operates correctly.

## Claims

1. An integrated circuit comprising a power device (3) for driving a resonant load (L) connected to a power supply, and a control circuit (2) for switching said power device (3) on and off, said control circuit (2) being placed in a disactivation state or an activation state in accordance with the value of a pulse input voltage (Vin), characterized by a protection circuit integrated on the same chip as said power device (3) and said control circuit (2), said protection circuit comprising a clamping circuit (1) suitable for causing the disactivation of said control circuit (2) and the quenching of the power device (3), independently of the value of said input voltage (Vin), when the current flowing through said power device (3) reaches a maximum preset value (Icmax), first circuit means (R1, C1, 8, E1, T1) suitable for inhibiting the operation of said clamping circuit (1) for a preset time interval after the power device (3) has been switched on and at least until the end of a first underground (V1) of the power device's voltage, i.e. a first period during which the voltage at the terminal of the power device connected to the resonant load is lower than the voltage at the ground of the integrated circuit, caused by the resonant load (L) due to said firing of the power device (3), and second circuit means (C2, TP4) suitable for keeping said clamping circuit (1) in operation during a second underground (V2) of said power device's voltage, i.e. a second period during which the voltage at the terminal of the power device connected to the resonant load is lower than the voltage at the ground of the integrated circuit, caused by said resonant load (L) following said quenching of the power device (3).

2. A circuit according to claim 1, characterized in that said first circuit means (R1, C1, 8, E1, T1) comprise an RC network (R1, C1) for the application of said pulse input voltage (Vin) to an input of a comparator (8) having a first reference voltage (E1), which comparator (8) in turn drives a transistor (T1) suitable for inhibiting the clamping circuit (1).

3. A circuit according to claim 2, characterized in that said RC network (R1, C1) comprises a first capacitor (C1) which is charged by said pulse input voltage (Vin) with a time constant such that the voltage across said input of the comparator (8) reaches the value of said first reference voltage (E1) at a time corresponding to said preset time interval.

4. A circuit according to claim 1, characterized in that it comprises a comparator (9) having a first input which receives a second reference voltage (E2), and a second input which receives a voltage equal to the product between the current flowing through the power device (3) and a detection resistance (R2) connected in series with said power device (3), said comparator (9) being suitable for causing said clamping circuit (1) to become active when said maximum preset value of current (Icmax), which is equal to the ratio between said second reference voltage (E2) and said detection resistance (R2), is reached.

5. A circuit according to claim 1, characterized in that said second circuit means (C2, TP4) consist of a second capacitor (C2) inserted in said clamping circuit (1) and arranged to be discharged by a parasite transistor (TP4) of the integrated circuit to keep the clamping circuit (1) in operation during said second voltage underground (V2).

6. A circuit according to claim 5, characterized in that said clamping circuit (1) comprises an input transistor (T2) and an output transistor (T3) across whose collector a high or low output (U) is taken in the case of the clamping circuit (1) being off or on, said second capacitor (C2) being connected to said input transistor (T2) so as to keep it cut off when said second capacitor (C2) is discharged during said second underground (V2) .

7. A circuit according to claim 6, characterized in that said second capacitor (C2) has a charging time constant such that the voltage across it does not reach the value necessary for firing of the input transistor (T2) during said second underground (V2).

8. A circuit according to claim 6, characterized in that said clamping circuit (1) also comprises a diode (D1) arranged in series with said output transistor (T3), the sum of the voltage across said diode (D1) and of the saturation voltage of the output transistor (T3) being effective for charging said second capacitor (C2).

9. A circuit according to claim 1, characterized in that said second circuit means (C2, TP4) comprise a capacitor (C2) formed by an N+/P junction located in an epitaxial region (23) contained within an insulation well (18, 19) of the type P in turn contained in an epitaxial layer (11) of the type N- grown on a substrate (10) of the type N+, an NPN transistor (TP4) having as collector an enriched region (27) of the type N+ of said epitaxial region (23), as base said insulation well (18, 19) of the type P and as emitter said epitaxial layer (11) and an underlying substrate (10), said collector of said NPN transistor (TP4) being connected by means of a surface metallization (62) to the N+ armature (37) of said capacitor (C2).

10. A circuit according to claim 9, characterized in that said NPN transistor (TP4) is a high-voltage transistor having a breakdown voltage that is higher than that which appears across said resonant load (L).

## Patentansprüche

1. Integrierte Schaltung mit einem Leistungselement (3) zum Treiben einer Resonanzlast (L), die mit einer Energieversorgung verbunden ist, und mit einer Steuerschaltung (2) zum Ein- und Ausschalten des Leistungselements (3), wobei sich die Steuerschaltung (2) nach Maßgabe des Werts einer Impuls-Eingangsspannung (Vin) in einem Deaktivierungszustand oder einem Aktivierungszustand befindet, gekennzeichnet durch eine Schutzschaltung, die auf demselben Chip wie das Leistungselement (3) und die Steuerschaltung (2) integriert ist, wobei die Schutzschaltung folgendes aufweist: eine Klemmschaltung (1), die zum Hervorrufen der Deaktivierung der Steuerschaltung (2) und zum Löschen des Leistungselements (3) unabhängig von dem Wert der Eingangsspannung (Vin) ausgelegt ist, wenn der das Leistungselement (3) durchfließende Strom einen maximalen voreingestellten Wert (Icmax) erreicht, eine erste Schaltungseinrichtung (R1, C1, 8, E1, T1), die zum Hemmen des Betriebs der Klemmschaltung (1) für einen vorbestimmten Zeitintervall nach dem Einschalten des Leistungselements (3) und wenigstens bis zum Ende einer ersten unter Massepotential liegenden Spannung (V1) der Spannung des Leistungselements ausgelegt ist, d.h. für eine erste Periode, in der die Spannung an dem mit der Resonanzlast verbundenen Anschluß des Leistungselements bedingt durch die Resonanzlast (L) aufgrund des Zündens des Leistungselements (3) niedriger ist als die Spannung an Masse der integrierten Schaltung, sowie eine zweite Schaltungseinrichtung (C2, TP4), die dazu ausgelegt ist, die Klemmschaltung (1) während einer zweiten unter Massepotential liegenden Spannung (V2) der Spannung des Leistungselements in Betrieb zu halten, d.h. während einer zweiten Periode, in der die Spannung an dem mit der Resonanzlast verbundenen Anschluß des Leistungselements bedingt durch die Resonanzlast (L) nach dem Löschen des Leistungselements (3) niedriger ist als die Spannung an Masse der integrierten Schaltung.

2. Schaltung nach Anspruch 1,
dadurch gekennzeichnet, daß die erste Schaltungseinrichtung (R1, C1, 8, E1, T1) ein RC-Glied (R1, C1) zum Anlegen der Impuls-Eingangsspannung (Vin) an einen Eingang eines Komparators (8) mit einer ersten Bezugsspannung (E1) aufweist, wobei der Komparator (8) wiederum einen Transistor (T1) ansteuert, der zum Hemmen der Klemmschaltung (1) ausgelegt ist.

3. Schaltung nach Anspruch 2,
dadurch gekennzeichnet, daß das RC-Glied (R1, C1) einen ersten Kondensator (C1) aufweist, der durch die Impuls-Eingangsspannung (Vin) geladen wird, und zwar mit einer derartigen Zeitkonstante, daß die Spannung über dem Eingang des Komparators (8) den Wert der ersten Bezugsspannung (E1) zu einem Zeitpunkt erreicht, der dem vorbestimmten Zeitintervall entspricht.

4. Schaltung nach Anspruch 1,
dadurch gekennzeichnet, daß sie einen Komparator (9) mit einem ersten Eingang, dem eine zweite Bezugsspannung (E2) zugeführt wird, und einem zweiten Eingang aufweist, dem eine Spannung zugeführt wird, die dem Produkt aus dem das Leistungselement (3) durchfließenden Strom und einem dem Leistungselement (3) in Reihe geschalteten Abtastwiderstand (R2) entspricht, wobei der Komparator (9) dazu ausgelegt ist, die Klemmschaltung (1) in den aktiven Zustand zu bringen, wenn der maximale voreingestellte Wert des Stroms (Icmax) erreicht ist, der gleich dem Verhältnis zwischen der zweiten Bezugsspannung (E2) und dem Abtastwiderstand (R2) ist.

5. Schaltung nach Anspruch 1,
dadurch gekennzeichnet, daß die zweite Schaltungseinrichtung (C2, TP4) aus einem zweiten Kondensator (C2) besteht, der in die Klemmschaltung (1) eingefügt ist und dazu ausgelegt ist, durch einen parasitären Transistor (TP4) der integrierten Schaltung entladen zu werden, um die Klemmschaltung (1) während der zweiten unter Massepotential liegenden Spannung (V2) in Betrieb zu halten.

6. Schaltung nach Anspruch 5,
dadurch gekennzeichnet, daß die Klemmschaltung (1) einen Eingangstransistor (T2) und einen Ausgangstransistor (T3) aufweist, über deren Kollektor in Abhängigkeit davon, ob die Klemmschaltung (1) ein- oder ausgeschaltet ist, ein hoher oder niedriger Ausgangswert (U) anliegt, wobei der zweite Kondensator (C2) mit dem Eingangstransistor (T2) verbunden ist, um diesen ausgeschaltet zu halten, wenn der zweite Kondensator (C2) während der zweiten unter Massepotential liegenden Spannung entladen wird.

7. Schaltung nach Anspruch 6,
dadurch gekennzeichnet, daß der zweite Kondensator (C2) eine derartige Ladezeitkonstante besitzt, daß die über ihm anliegende Spannung nicht den Wert erreicht, der zum Zünden des Eingangstransistors (T2) während der zweiten unter Massepotential liegenden Spannung (V2) erforderlich ist.

8. Schaltung nach Anspruch 6,
dadurch gekennzeichnet, daß die Klemmschaltung (1) ferner eine Diode (D1) aufweist, die in Reihe mit dem Ausgangstransistor (T3) angeordnet ist, wobei die Summe aus der über der Diode (D1) anliegenden Spannung und der Sättigungsspannung des Ausgangstransistors (T3) ein Laden des zweiten Kondensators (C2) bewirkt.

9. Schaltung nach Anspruch 1,
dadurch gekennzeichnet, daß die zweite Schaltungseinrichtung (C2, TP4) einen Kondensator (C2) aufweist, der durch einen N⁺/P-Übergang gebildet ist, der sich in einem Epitaxiebereich (23) befindet, der in einer P-leitenden Isolierwanne (18, 19) enthalten ist, die wiederum in einer durch Aufwachsen auf einem N⁺-leitenden Substrat (10) gebildeten N⁻-leitenden Epitaxieschicht (11) enthalten ist, wobei ein NPN-Transistor (TP4) als Kollektor einen angereicherten N⁺-leitenden Bereich (27) des Epitaxiebereichs (23), als Basis die P-leitende Isolierwanne (18, 19) und als Emitter die Epitaxieschicht und ein darunterliegendes Substrat (10) aufweist, wobei der Kollektor des NPN-Transistors (TP4) mittels einer Oberflächenmetallisierung (62) mit der N⁺-leitenden Elektrode (37) des Kondensators (C2) verbunden ist.

10. Schaltung nach Anspruch 9,
dadurch gekennzeichnet, daß der NPN-Transistor (TP4) ein für hohe Spannung ausgelegter Transistor ist, der eine Durchbruchspannung besitzt, die höher ist als die Spannung, die über der Resonanzlast (L) auftritt.

## Revendications

1. Circuit intégré comprenant un dispositif de puissance (3) pour piloter une charge résonante (L) connectée à une source d'alimentation, et un circuit de commande (2) pour commuter le dispositif de puissance (3) à la fermeture et à l'ouverture, le circuit de commande (2) étant placé dans un état de désactivation ou dans un état d'activation selon la valeur d'une tension d'entrée en impulsions (Vin), caractérisé par un circuit de protection, intégré sur la même puce que le dispositif de puissance (3) et le circuit de commande (2), le circuit de protection comprenant un circuit de verrouillage (1) propre à provoquer la désactivation du circuit de commande (2) et le blocage du dispositif de puissance (3), indépendamment de la valeur de la tension d'entrée (Vin), quand le courant circulant dans le dispositif de puissance (3) atteint une valeur maximum prédéterminée (Icmax), un premier moyen de circuit (R1, C1, 8, E1, T1) propre à inhiber le fonctionnement du circuit de verrouillage (1) pendant un intervalle de temps prédéterminé après que le dispositif de puissance (3) a été commuté à la fermeture et au moins jusqu'à la fin d'un premier passage en dessous du niveau de la masse (V1) de la tension du dispositif de puissance, c'est-à-dire une première durée pendant laquelle la tension sur la borne du dispositif de puissance connectée au dispositif résonant est inférieure à la tension de la masse du circuit intégré, provoqué par la charge résonante (L) par suite du déclenchement du dispositif de puissance (3), et un second moyen de circuit (C2, TP4) propre à maintenir le circuit de verrouillage (1) en fonctionnement pendant un second passage sous le niveau de la masse (V2) de la tension du dispositif de puissance, c'est-à-dire une seconde durée pendant laquelle la tension sur la borne du dispositif de puissance connectée à la charge résonante est inférieure à la tension de la masse du circuit intégré, provoqué par le fait que la charge résonante (L) suit le blocage du dispositif de puissance (3).

2. Circuit selon la revendication 1, caractérisé en ce que le premier moyen de circuit (R1, C1, 8, El, T1) comprend un réseau RC (R1, C1) pour l'application de la tension d'entrée en impulsions (Vin) sur une entrée d'un comparateur (8) recevant une première tension de référence (El), le comparateur (8) pilotant lui-même un transistor (T1) propre à inhiber le circuit de verrouillage (1).

3. Circuit selon la revendication 2, caractérisé en ce que le réseau RC (R1, C1) comprend un premier condensateur (C1) qui est chargé par la tension d'entrée en impulsions (Vin) avec une constante de temps telle que la tension aux bornes de l'entrée de comparateur (8) atteint la valeur de la première tension de référence (E1) à un instant qui correspond audit intervalle de temps prédéterminé.

4. Circuit selon la revendication 1, caractérisé en ce qu'il comprend un comparateur (9) ayant une première entrée qui reçoit une seconde tension de référence (E2) et une seconde entrée qui reçoit une tension égale au produit entre le courant circulant dans le dispositif de puissance (3) et une résistance de détection (R2) connectée en série avec le dispositif de puissance (3), le comparateur (9) étant propre à amener le circuit de verrouillage (1) à devenir actif quand la valeur maximale prédéterminée du courant (Icmax), qui est égale au rapport entre la seconde tension de référence (E2) et la résistance de détection (R2), est atteinte.

5. Circuit selon la revendication 1, caractérisé en ce que le second moyen de circuit (C2, TP4) comprend un second condensateur (C2) inséré dans le circuit de verrouillage (1) et disposé pour être déchargé par un transistor parasite (TP4) du circuit intégré pour maintenir le circuit de verrouillage (1) en fonctionnement pendant le second passage de la tension sous le niveau de la masse (V2).

6. Circuit selon la revendication 5, caractérisé en ce que le circuit de verrouillage (1) comprend un transistor d'entrée (T2) et un transistor de sortie (T3) sur le collecteur duquel est prise une tension de sortie haute ou basse (U) selon que le circuit de verrouillage (1) est bloqué ou passant, le second condensateur (C2) étant connecté au transistor d'entrée (T2) de façon à le maintenir bloqué quand le second condensateur (C2) est déchargé pendant le second passage sous le niveau de la masse (V2).

7. Circuit selon la revendication 6, caractérisé en ce que le second condensateur (C2) a une constante de temps de charge telle que la tension à ses bornes n'atteint pas la valeur nécessaire à déclencher le transistor d'entrée (T2) pendant le second passage sous le niveau de la masse (V2).

8. Circuit selon la revendication 6, caractérisé en ce que le circuit de verrouillage (1) comprend une diode (D1) disposée en série avec le transistor de sortie (T3), la somme de la tension aux bornes de la diode (D1) et de la tension de saturation du transistor de sortie (T3) agissant pour charger le second condensateur (C2).

9. Circuit selon la revendication 1, caractérisé en ce que le second moyen de circuit (C2, TP4) comprend un condensateur (C2) constitué d'une jonction N⁺/P disposée dans une région épitaxiale (23) contenue dans un caisson isolant (18, 19) de type P lui-même contenu dans une couche épitaxiale (11) de type N⁻ formée sur un substrat (10) de type N⁺, un transistor NPN (TP4) ayant comme collecteur une région enrichie (27) de type N⁺ de la région épitaxiale (23), comme base le caisson d'isolement (18, 19) de type P et comme émetteur la couche épitaxiale (11) et le substrat sous-jacent (10), le collecteur du transistor NPN (TP4) étant connecté par une métallisation superficielle (62) à l'armature de type N⁺ (37) du condensateur (C2).

10. Circuit selon la revendication 9, caractérisé en ce que le transistor NPN (TP4) est un transistor haute tension ayant une tension de claquage supérieure à celle qui apparaît aux bornes de la charge résonante (L).
